# EUROPÄISCHE PATENTSCHRIFT

(11) **EP 4 049 367 B1**
(45) Veröffentlichungstag und Bekanntmachung des Hinweises auf die Patenterteilung: **19.08.2026**
(21) Anmeldenummer: 20824126.5
(22) Anmeldetag: 02.12.2020
(51) Int. Cl.: H02S 40/42

(54) **ENERGIEEFFIZIENTES KÜHLEN EINER PEROWSKIT-SOLARZELLE**
ENERGY-EFFICIENT COOLING OF A PEROVSKITE SOLAR CELL
REFROIDISSEMENT ÉNERGÉTIQUEMENT EFFICACE D'UNE CELLULE SOLAIRE EN PÉROVSKITE

(30) Priorität: 20.12.2019 EP 19218897
(43) Veröffentlichungstag der Anmeldung: 31.08.2022
(73) Patentinhaber: Siemens Energy Global GmbH & Co. KG, 81739 München (DE)
(72) Erfinder: BODAMMER, Georg, 80796 München (DE); KUSIAN, Wilhelm, 85560 Ebersberg (DE); LEIBL, Stephanie, 85609 Aschheim (DE); POHLE, Roland, 85570 Herdweg (DE); SIMON, Elfriede, 80639 München (DE); VON SICARD, Oliver, 81541 München (DE); FLEISCHER, Maximilian, 85635 Höhenkirchen (DE)
(86) Internationale Anmeldenummer: PCT/EP2020/084191
(87) Internationale Veröffentlichungsnummer: WO 2021/121987

(56) Entgegenhaltungen:
- DE-A1- 102007 055 462
- US-B1- 10 480 730
- SO-MIN YOO ET AL: "From Dye Sensitized to Perovskite Solar Cells, The Missing Link", ARXIV.ORG, CORNELL UNIVERSITY LIBRARY, 201 OLIN LIBRARY CORNELL UNIVERSITY ITHACA, NY 14853, 28 May 2019 (2019-05-28), XP081371419

## Beschreibung

### Technisches Gebiet

Die Erfindung betrifft ein Verfahren zur Steuerung einer Kühlvorrichtung zur aktiven Kühlung einer Perowskit-Solarzelle. Des Weiteren betrifft die Erfindung eine Photovoltaik-Einrichtung mit einem mindestens eine Perowskit-Solarzelle aufweisenden Perowskit-Photovoltaikmodul und einer Kühlvorrichtung zur aktiven Kühlung der Perowskit-Solarzelle.

### Stand der Technik

Es ist bekannt, dass der Wirkungsgrad von Perowskit-Solarzellen bei hohen Temperaturen typischerweise sinkt. Dieses Sinken bzw. diese Verschlechterung des Wirkungsgrads bei hohen Temperaturen ist im Allgemeinen nicht nur stärker ausgeprägt als bei konventionellen kristallinen Silicium-Solarzellen, sondern ist unter Umständen auch irreversibel. Die Temperatur, ab der die Gefahr besteht, dass die Perowskit-Solarzelle dauerhaft geschädigt wird, wird auch als kritische Temperatur bezeichnet. Es ist somit wichtig, dass die Temperatur der Perowskit-Solarzelle auch bei z.B. hoher solarer Einstrahlung stets unter dieser kritischen Temperatur bleibt. Das Dokument US10480730B1 beschreibt ein Verfahren für photovoltaische Vorrichtungen.

Die kritische Temperatur hängt stark von der Struktur, Materialzusammensetzung und Prozessierung der Perowskit-Solarzelle ab. Die kritische Temperatur einer Perowskit-Solarzelle kann unter gewissen Umständen bei so niedrigen Werten wie 50°C oder 60°C liegen - eine Temperatur, die die Solarzelle im Betrieb gewöhnlicherweise rasch erreichen kann.

Ein erster Ansatz, der Herausforderung der degradierenden Perowskit-Solarzellen bei Temperaturen oberhalb der kritischen Temperatur zu begegnen, ist eine Modifikation der Struktur, Materialzusammensetzung und/oder Prozessierung der Perowskit-Solarzelle. Die Modifikation erfolgt mit der Zielsetzung, das Niveau (in anderen Worten, die Höhe) der kritischen Temperatur der Perowskit-Solarzelle zu erhöhen.

Ein zweiter Ansatz besteht darin, Wege und Mittel zu finden, die Verschlechterung des Wirkungsgrads aufgrund hoher Temperaturen, denen die Perowskit-Solarzelle ausgesetzt ist, zumindest teilweise zu "heilen". Dieser Ansatz verfolgt, in anderen Worten, das Ziel, die vermeintlich irreversible Schädigung des Perowskit-Materials doch zumindest teilweise wieder rückgängig zu machen.

Weder mit dem ersten noch mit dem zweiten Ansatz sind bisher vollends zufriedenstellende und praktikable Lösungen erzielt worden.

Aus DE 10 2007 055 462 A1 geht ein Verfahren zur Regelung einer Photovoltaik-Anlage hervor, wobei die Photovoltaik-Anlage mindestens eine Solarzelle und mindestens ein Peltier-Element aufweist, welches thermisch mit der Solarzelle gekoppelt ist, wobei das Peltier-Element für eine Kühlung und/oder Beheizung der Solarzelle verwendet wird. Die Solarzellen sind an einem plattenförmig ausgebildeten Halterungselement fixiert, welches durch eine Aluminiumtafel gebildet ist. Die Temperatur der Solarzellen wird mit Hilfe eines an der Rückseite der Aluminiumtafel angeordneten Temperatursensors überwacht, wobei die Überwachung uhrzeitabhängig ausschließlich zu Zeiten erfolgt, zu denen eine ausreichende Sonneneinstrahlung möglich ist. Zur Tageszeit wird dann in regelmäßigen Abständen die Temperatur gemessen und mit einer maximalen Grenztemperatur Tmax verglichen, welche 40°C beträgt. Wird im Rahmen der Überwachung eine Temperatur T ermittelt, welche über der maximalen Grenztemperatur Tmax liegt, so wird eine Spannung derart an die Peltier-Elemente angelegt, dass die Solarzellen gekühlt werden.

Die Aufgabe der vorliegenden Erfindung besteht darin, ein alternatives Konzept zu entwickeln, um das Risiko einer dauerhaften Schädigung der Perowskit-Solarzelle aufgrund thermischer Effekte zu reduzieren.

### Allgemeine Beschreibung der Erfindung

Diese Aufgabe wird von dem Verfahren zur Steuerung einer Kühlvorrichtung sowie der Photovoltaik-Einrichtung gemäß der unabhängigen Ansprüche gelöst. Vorteilhafte Weiterbildungen und Ausführungsformen sind in den abhängigen Ansprüchen, der Beschreibung und den Abbildungen offenbart.

Das erfindungsgemäße Verfahren betrifft die Steuerung einer Kühlvorrichtung zur aktiven Kühlung einer Perowskit-Solarzelle, wobei die Perowskit-Solarzelle Teil eines Perowskit-Photovoltaikmoduls ist. Das Verfahren umfasst die folgenden Schritte:
- Ermitteln eines Maßes für die innere Temperatur der Perowskit-Solarzelle und
- Aktivieren der Kühlvorrichtung, wenn das ermittelte Maß für die innere Temperatur der Perowskit-Solarzelle größer als ein entsprechendes Maß eines vorbestimmten Temperaturschwellwerts ist,
wobei die Perowskit-Solarzelle eine lichtabsorbierende Schicht aufweist und es sich bei dem Maß für die innere Temperatur um die tatsächliche Temperatur der lichtabsorbierenden Schicht der Perowskit-Solarzelle handelt.

Die Perowskit-Solarzelle wird also bei Bedarf, nämlich bei Überschreiten eines gewissen Schwellwerts der Temperatur, der vorteilhafterweise kleiner als die kritische Temperatur der Perowskit-Solarzelle ist, gekühlt. Damit soll verhindert werden, dass die Perowskit-Solarzelle höheren Temperaturen als ihrer kritischen Temperatur ausgesetzt ist. Eine unter Umständen irreversible Schädigung der Solarzelle kann damit von vornherein vermieden werden.

Die Steuerung der Kühlung basiert auf der inneren Temperatur der Perowskit-Solarzelle bzw. einem entsprechenden Maß für die innere Temperatur. Das Maß für die innere Temperatur der Perowskit-Solarzelle wird insbesondere kontinuierlich oder in Intervallen ermittelt. Übersteigt dieses Maß einen vorbestimmten Schwellwert, wird die Kühlvorrichtung aktiviert. Fällt das Maß für die innere Temperatur wieder unter den Schwellwert, wird die Kühlvorrichtung deaktiviert. Dies ermöglicht eine energiesparende und damit effiziente, bedarfsgerechte Kühlung der Perowskit-Solarzelle(n).

Ein wichtiger Aspekt der vorliegenden Erfindung ist, dass die Kühlvorrichtung in Abhängigkeit von der inneren Temperatur der Perowskit-Solarzelle aktiviert wird. Die innere Temperatur - im Englischen fachsprachlich auch als "bulk temperature" bezeichnet - ist hierbei in Abgrenzung zur Oberflächentemperatur (englisch: "surface temperature") zu verstehen. Die innere Temperatur der Solarzelle bezieht sich insbesondere auf die Temperatur der lichtabsorbierenden Schicht der Solarzelle. Im Fall einer Perowskit-Solarzelle mit einem p-i-n-Aufbau, also aufweisend eine lochleitende, eine intrinsische und eine elektronleitende Schicht, umfasst die lichtabsorbierende Schicht insbesondere die intrinsische Schicht. Die intrinsische Schicht weist bei einer Perowskit-Solarzelle z.B. die (Kristall-)Struktur CH₃NH₃PbI₃ auf. Da bei einer Perowskit-Solarzelle vor allem die intrinsische, perowskitbasierte Schicht irreversibel degradieren kann, wenn sie Temperaturen oberhalb der kritischen Temperatur ausgesetzt ist, ist vor allem die Temperatur dieses Bereichs der Solarzelle, also ihre innere Temperatur, wesentlich. Ist andererseits beispielsweise die Temperatur an den Vorderseitenkontakten der Perowskit-Solarzelle zwar oberhalb der kritischen Temperatur, die tatsächliche Temperatur der lichtabsorbierenden Schicht jedoch unterhalb der kritischen Temperatur, befindet sich die Perowskit-Solarzelle noch "im grünen Bereich" und eine Aktivierung einer Kühlung der Solarzelle muss noch nicht in die Wege geleitet werden.

Ein weiterer wichtiger Aspekt der Erfindung besteht darin, dass die Perowskit-Solarzelle gemäß dem erfindungsgemäßen Verfahren aktiv gekühlt wird. Dies ist insbesondere in Abgrenzung zu einer permanenten Kühlung zu sehen. Da die innere Temperatur der Perowskit-Solarzelle bzw. ein entsprechendes Maß dafür als Regelgröße für die Kühlvorrichtung verwendet wird, ist sichergestellt, dass die Kühlung nur dann läuft, wenn auch Kühlbedarf besteht. Das erfindungsgemäße Verfahren ist somit energiesparend und schont damit Geld und Ressourcen.

Eine aktive Kühlung hat vor allem den Vorteil, dass sie energiesparend ist, da nur dann gekühlt wird, wenn es notwendig ist. Vorteilhafterweise hat die aktive Kühlung eine relativ hohe Kühlleistung, um mit einer möglichst hohen Wahrscheinlichkeit ein Übersteigen der inneren Temperatur über die kritische Temperatur der Solarzelle auch sicher zu verhindern. Das erfindungsgemäße Verfahren stellt also einen zuverlässigen und energieeffizienten Kühlmechanismus für eine Perowskit-Solarzelle dar, der das Risiko einer dauerhaften Schädigung der Perowskit-Solarzelle aufgrund thermischer Effekte reduziert.

Eine aktive Kühlung ist auch in Abgrenzung zur sogenannten Hinterlüftung zu sehen. Die Hinterlüftung eines Photovoltaikmoduls ist von Photovoltaikmodulen mit konventionellen kristallinen Silicium-Solarzellen bekannt. Hierfür werden die Photovoltaikmodule in einem gewissen Abstand zum Dach montiert. Um eine hinreichende Hinterlüftung der Photovoltaikmodule zu erreichen, ist es empfehlenswert, einen Abstand zwischen Dach und Modul von circa 10 cm einzuhalten. Die Hinterlüftung der Module funktioniert über Konvektionsluft. In dem Raum zwischen Photovoltaikmodul und Dachhaut entsteht ein Kamineffekt, wobei die Stärke des Effekts (und damit der Kühlung) sowohl von der Größe des Abstands zwischen Dach und Modul als auch von dem Material der Dachhaut und der Unterseite der Module abhängt. Es gibt höhenverstellbare Dachhaken, damit ein gewünschter Abstand leichter eingehalten werden kann.

Selbstverständlich weist das Perowskit-Photovoltaikmodul in der Regel mehr als eine Perowskit-Solarzelle, nämlich eine Vielzahl von Perowskit-Solarzellen auf. Eine Perowskit-Solarzelle kann auch Teil einer Tandemzelle sein, die aus einer Perowskit-Solarzelle und einer weiteren Solarzelle, beispielsweise einer konventionellen Silicium-Solarzelle, aufgebaut ist. Für derartige Tandemsolarzellen sind im Labormaßstab kürzlich beeindruckende 28% Wirkungsgrad erreicht worden.

Der erste Verfahrensschritt beinhaltet das Ermitteln eines Maßes für die innere Temperatur der Perowskit-Solarzelle. Sollte das Perowskit-Photovoltaikmodul mehrere Perowskit-Solarzellen aufweisen, kann der erste Verfahrensschritt auch das Ermitteln der Maße für die inneren Temperaturen mehrerer Perowskit-Solarzellen des Perowskit-Photovoltaikmoduls beinhalten.

Unter dem Maß für die innere Temperatur wird jeglicher Parameter verstanden, der dazu geeignet ist, die innere Temperatur der Perowskit-Solarzelle zu charakterisieren. Dies kann ganz direkt die tatsächliche Temperatur in der Einheit Kelvin (oder Grad Celsius oder Fahrenheit) sein. Dies kann aber beispielsweise auch eine Stromstärke in Ampere oder eine Spannung in Volt sein, die gar nicht in eine konkrete Temperatur umgerechnet werden, dennoch aber zur Einschätzung herangezogen werden können, ob sich die momentane innere Temperatur der Perowskit-Solarzelle ober- oder unterhalb eines vorbestimmten Temperaturschwellwerts befindet.

Der vorbestimmte Temperaturschwellwert wird vorteilhafterweise so ausgewählt, dass er etwas unterhalb der kritischen Temperatur liegt. Je nach Ausgestaltung der Kühlvorrichtung, insbesondere hinsichtlich der Kühlleistung, sollte der Temperaturschwellwert so gewählt werden, dass gewährleistet ist, dass nach Überschreiten des Temperaturschwellwerts und Aktivieren der Kühlvorrichtung die Temperatur im Regelfall nur um so viel weiter ansteigt, dass sie immer noch unterhalb der kritischen Temperatur der Perowskit-Solarzelle bleibt.

Unter einem "vorbestimmten" Temperaturschwellwert wird ein vorgegebener Temperaturschwellwert verstanden. Eingedenk der Tatsache, dass die kritische Temperatur einer Perowskit-Solarzelle, ab der eine irreversible Degradation ihres Wirkungsgrads droht, stark vom konkreten Zelltyp abhängt, sollte der entsprechende Temperaturschwellwert individuell festgelegt werden.

Es sind verschiedene Verfahren denkbar, wie die innere Temperatur oder ein Maß dafür konkret ermittelt werden kann.

Ein erstes Verfahren basiert auf Impedanzspektroskopie, insbesondere elektrochemischer Impedanzspektroskopie. Hierfür wird eine Wechselspannung an die Perowskit-Solarzelle angelegt und für verschiedene Frequenzen der Wechselspannung der resultierende Stromfluss gemessen. Basierend auf einer geeigneten Auftragung der Messergebnisse, beispielsweise in einem sogenannten Bode- oder Nyquist-Diagramm, können anschließend Rückschlüsse auf interne Parameter der Perowskit-Solarzelle gezogen werden, z.B. Ladungsträgertransport oder Rekombinationsrate der Ladungsträger. Insbesondere kann auch die innere Temperatur der Peroswkit-Solarzelle mittels Impedanzspektroskopie bestimmt werden, wie beispielsweise in der internationalen Patentanmeldung PCT/EP2019/074317, eingereicht am 12.09.2019, beschrieben.

Ein zweites Verfahren zur Ermittlung der inneren Temperatur der Peroswkit-Solarzelle beinhaltet die Verwendung eines Thermoelements. Ein Thermoelement besteht aus einem Paar metallischer Leiter aus unterschiedlichem Material, die an einem Ende verbunden sind und aufgrund des thermoelektrischen Effektes zur Temperaturmessung geeignet sind. Im Prinzip liefert das Thermoelement elektrische Energie aus Wärme bei einer Temperaturdifferenz entlang des elektrischen Leiters. Die dabei auftretende elektrische Spannung an den Enden der metallischen Leiter ist vergleichsweise klein und bewegt sich im Bereich einiger 10 µV pro 1°C Temperaturdifferenz. Die beiden metallischen Leiter des Thermoelements werden vorteilhafterweise direkt mit der lichtabsorbierenden Schicht der Perowskit-Solarzelle, also z.B. ihrer intrinsischen Schicht, verbunden. Eine solche Verbindung wird in der Regel dauerhaft eingerichtet, so dass die innere Temperatur der Solarzelle beim Betrieb des Perowskit-Photovoltaikmoduls kontinuierlich überwacht werden kann.

Auch für die konkrete Ausgestaltung der Kühlvorrichtung zur aktiven Kühlung der Perowskit-Solarzelle sind verschiedene Realisierungen denkbar.

Beispielsweise ist die Kühlung der Solarzellen mittels einer Kühlflüssigkeit möglich. Die Kühlflüssigkeit kann z.B. in Rohren oder Schläuchen in der Nähe der Solarzellen geführt werden. Die Kühlvorrichtung würde in diesem Fall sinnvollerweise einen Zu- und Ablauf aufweisen, wobei die Temperatur der Kühlflüssigkeit im Zulauf niedriger als der vorbestimmte Temperaturschwellwert ist, bei der die Kühlung aktiviert wird. Die Kühlflüssigkeit kann im Wesentlichen aus Wasser bestehen, dem optional Zusätze zur Erniedrigung des Gefrierpunkts und/oder zur Erhöhung des Siedepunkts hinzugefügt sind.

Eine flüssigkeitsbasierte Kühlung der Perowskit-Solarzellen ist beispielsweise auch mittels Regenwasser möglich, das gesammelt wird und kontrolliert über eine geneigte Oberfläche des Perowskit-Photovoltaikmoduls geleitet wird. In diesem Fall wird bei Überschreiten des vorbestimmten Temperaturschwellwerts Regenwasser über die Moduloberfläche geleitet, wobei die Temperatur des Wassers niedriger als die Temperatur des Photovoltaikmoduls ist und somit eine Kühlung des Moduls und der darin enthaltenen Perowskit-Solarzellen bewirkt wird. Die Steuerung der Kühlung basiert auf der inneren Temperatur der Perowskit-Solarzelle bzw. einem entsprechenden Maß für die innere Temperatur. Das Maß für die innere Temperatur der Perowskit-Solarzelle wird also kontinuierlich oder in Intervallen ermittelt. Übersteigt dieses Maß einen vorbestimmten Schwellwert, wird die Kühlvorrichtung aktiviert, im Fall der Kühlung mittels eines Reservoirs an Regenwasser beispielsweise durch Öffnen eines Ventils am Ausfluss des Reservoirs. Die Nutzung von Regenwasser ist unter dem Aspekt vorteilhaft, dass damit etwaige kalkhaltige Rückstände auf der Moduloberfläche vermieden werden können. Prinzipiell sind aber natürlich auch alternative Kühlflüssigkeiten denkbar. Ferner ist auch die Nutzung von Regenwasser in einem offenen System denkbar, in dem es verdunsten kann und die Verdampfungswärme - auch als "Verdunstungskälte" bezeichnet - genutzt wird, um die Perowskit-Solarzelle(n) des Photovoltaikmoduls zu kühlen.

In einer anderen Ausführungsform der Erfindung weist die Kühlvorrichtung einen Radiator zur Abgabe von Wärme durch Wärmestrahlung auf. Der Radiator besteht beispielsweise aus einem gut wärmeleitenden Metall und hat eine Oberfläche mit einem hohen Emissionsgrad.

Der Radiator - aber auch andere Ausgestaltungsformen der Kühlvorrichtung - sind insbesondere auf der der Sonne abgewandten Seite des Perowskit-Photovoltaikmoduls angeordnet. Dies hat zum einen den Vorteil, dass sie keinerlei Abschattung der Solarzellen bewirken. Zum anderen wird dadurch ein Aufheizen der Kühlvorrichtung minimiert.

In einer weiteren Ausführungsform der Erfindung weist die Kühlvorrichtung ein Peltier-Element auf. Bei Aktivierung der Kühlvorrichtung erzeugt ein Stromfluss durch das Peltier-Element eine Reduktion der inneren Temperatur der Perowskit-Solarzelle.

Unter einem Peltier-Element wird hierbei ein elektrothermischer Wandler verstanden, der basierend auf dem Peltier-Effekt bei Stromdurchfluss eine Temperaturdifferenz erzeugt. Peltier-Elemente können damit zur Kühlung eines mit dem Peltier-Element thermisch leitend verbundenen Gegenstands verwendet werden. Peltier-Elemente werden in dieser Verwendung auch als Peltier-Kühler bzw. TEC (engl. thermoelectric cooler) bezeichnet.

In einer weiteren Ausführungsform der Erfindung weist die Kühlvorrichtung eine Vielzahl von Kanälen in einer Abdeckplatte des Perowskit-Photovoltaikmoduls auf. Die Abdeckplatte ist beispielsweise als Glasscheibe, insbesondere als Einscheiben-Sicherheitsglas, realisiert. Die Kanäle haben eine im Vergleich zu den übrigen Dimensionen des Photovoltaikmoduls kleine Größe und werden fachsprachlich auch als microchannels bezeichnet. Bei Aktivierung der Kühlvorrichtung fließt eine Kühlflüssigkeit durch die Kanäle. Die Kühlflüssigkeit hat wiederum zumindest im Vorlauf eine niedrigere Temperatur als die zu kühlende Komponente, hier die Perowskit-Solarzelle. Somit nimmt die Kühlflüssigkeit einen Teil der Wärmeenergie der Perowskit-Solarzelle auf und sorgt damit für eine Kühlung der inneren Temperatur der Perowskit-Solarzelle.

Ist die Kühlvorrichtung beispielsweise am Äußeren des Perowskit-Photovoltaikmoduls angeordnet, besteht vorteilhafterweise eine gute thermische Leitung von dem Kühlmedium zu der zu kühlenden Perowskit-Solarzelle.

Die Erfindung betrifft außer dem beschriebenen erfindungsgemäßen Verfahren zur Steuerung der Kühlvorrichtung auch eine Photovoltaik-Einrichtung mit einem Perowskit-Photovoltaikmodul und einer Kühlvorrichtung. Das Perowskit-Photovoltaikmodul weist eine oder mehrere Perowskit-Solarzellen auf. Die Kühlvorrichtung ist zur aktiven Kühlung der Perowskit-Solarzelle geeignet. Die Photovoltaik-Einrichtung weist ferner eine Steuerungsvorrichtung zur Steuerung der Kühlvorrichtung auf. Die Steuerungsvorrichtung ist insbesondere dazu ausgestaltet, ein Verfahren gemäß einem der oben beschriebenen Ausführungsformen auszuführen.

Die aktive Kühlung des Perowskit-Photovoltaikmoduls kann optional auch mit einem passiven Kühlmechanismus des Moduls bzw. mit einem passiven Temperaturstabilisierungsmechanismus des Perowskit-Photovoltaikmoduls kombiniert werden. Bekannte passive Temperaturstabilisierungsmechanismen in diesem Zusammenhang sind das Bereitstellen einer großen thermischen Masse in Form z.B. eines Wassertanks auf der Rückseite des Photovoltaikmoduls oder die Verwendung eines Latentwärmespeichers, der einen Großteil der ihm zugeführten thermischen Energie in Form von latenter Wärme (z.B. für einen Phasenwechsel von fest zu flüssig) speichert.

## Patentansprüche

1. Verfahren zur Steuerung einer Kühlvorrichtung zur aktiven Kühlung einer Perowskit-Solarzelle, wobei die Perowskit-Solarzelle Teil eines Perowskit-Photovoltaikmoduls ist, das Verfahren umfassend die folgenden Schritte:
- Ermitteln eines Maßes für die innere Temperatur der Perowskit-Solarzelle und
- Aktivieren der Kühlvorrichtung, wenn das ermittelte Maß für die innere Temperatur der Perowskit-Solarzelle größer als ein entsprechendes Maß eines vorbestimmten Temperaturschwellwerts ist, wobei die Perowskit-Solarzelle eine lichtabsorbierende Schicht aufweist und es sich bei dem Maß für die innere Temperatur um die tatsächliche Temperatur der lichtabsorbierenden Schicht der Perowskit-Solarzelle handelt.

2. Verfahren nach Anspruch 1,
wobei das Maß für die innere Temperatur der Perowskit-Solarzelle mittels Impedanzspektroskopie ermittelt wird.

3. Verfahren nach einem der Ansprüche 1 oder 2,
wobei das Maß für die innere Temperatur der Perowskit-Solarzelle mittels eines Thermoelements ermittelt wird.

4. Verfahren nach einem der vorhergehenden Ansprüche,
wobei sich die Kühlvorrichtung im Wesentlichen auf der der Sonne abgewandten Seite des Perowskit-Photovoltaikmoduls befindet.

5. Verfahren nach einem der vorhergehenden Ansprüche,
wobei die Kühlvorrichtung ein Peltier-Element umfasst und bei Aktivierung der Kühlvorrichtung ein Stromfluss durch das Peltier-Element eine Reduktion der inneren Temperatur der Perowskit-Solarzelle erzeugt.

6. Verfahren nach einem der vorhergehenden Ansprüche,
wobei die Kühlvorrichtung eine Kühlflüssigkeit umfasst, die zumindest bei Aktivierung der Kühlvorrichtung in einem Zulauf der Kühlvorrichtung eine niedrigere Temperatur als den Temperaturschwellwert aufweist.

7. Verfahren nach einem der vorhergehenden Ansprüche,
wobei die Kühlvorrichtung einen Radiator zur Abgabe von Wärme durch Wärmestrahlung aufweist.

8. Verfahren nach einem der vorhergehenden Ansprüche,
wobei die Kühlvorrichtung eine Vielzahl von Kanälen in einer Abdeckplatte des Perowskit-Photovoltaikmoduls aufweist.

9. Verfahren nach Anspruch 8,
wobei bei Aktivierung der Kühlvorrichtung eine Kühlflüssigkeit die Kanäle durchfließt und einen Teil der Wärmeenergie der Perowskit-Solarzelle aufnimmt.

10. Verfahren nach einem der vorhergehenden Ansprüche,
wobei das Perowskit-Photovoltaikmodul einen Rahmen aufweist und die Perowskit-Solarzelle thermisch leitend mit dem Rahmen verbunden ist.

## Claims

1. A method for controlling a cooling device for actively cooling a perovskite solar cell, wherein the perovskite solar cell is part of a perovskite photovoltaic module, the method comprising the following steps:
- determining a measure of the internal temperature of the perovskite solar cell, and
- activating the cooling device when the determined measure of the internal temperature of the perovskite solar cell is greater than a corresponding measure of a predetermined temperature threshold, wherein the perovskite solar cell has a light-absorbing layer, and the measure of the internal temperature is the actual temperature of the light-absorbing layer of the perovskite solar cell.

2. The method according to claim 1,
wherein the measure of the internal temperature of the perovskite solar cell is determined by means of impedance spectroscopy.

3. The method according to any one of claims 1 or 2,
wherein the measure of the internal temperature of the perovskite solar cell is determined by means of a thermocouple.

4. The method according to any one of the preceding claims, wherein the cooling device is located substantially on the side of the perovskite photovoltaic module facing away from the sun.

5. The method according to any one of the preceding claims,
wherein the cooling device comprises a Peltier element, and a current flow through the Peltier element, upon activation of the cooling device, generates a reduction of the internal temperature of the perovskite solar cell.

6. The method according to any one of the preceding claims, wherein the cooling device comprises a cooling liquid having, at least upon activation of the cooling device, a temperature in an inflow of the cooling device that is lower than the temperature threshold.

7. The method according to any one of the preceding claims, wherein the cooling device has a radiator for emitting heat by heat radiation.

8. The method according to any one of the preceding claims, wherein the cooling device has a plurality of channels in a cover plate of the perovskite photovoltaic module.

9. The method according to claim 8,
wherein, upon activation of the cooling device, a cooling liquid flows through the channels and absorbs a part of the thermal energy of the perovskite solar cell.

10. The method according to any one of the preceding claims, wherein the perovskite photovoltaic module has a frame, and the perovskite solar cell is thermally conductively connected to the frame.

## Revendications

1. Procédé de commande d'un dispositif de refroidissement pour le refroidissement actif d'une cellule solaire en pérovskite, ladite cellule solaire en pérovskite faisant partie d'un module photovoltaïque en pérovskite, le procédé comprenant les étapes suivantes :
- la détermination d'une mesure de la température interne de la cellule solaire en pérovskite, et
- l'activation du dispositif de refroidissement lorsque la mesure déterminée de la température interne de la cellule solaire en pérovskite est supérieure à une mesure correspondante d'une valeur seuil de température prédéterminée, ladite cellule solaire en pérovskite présentant une couche d'absorption de lumière et ladite mesure de la température interne étant la température réelle de la couche d'absorption de lumière de la cellule solaire en pérovskite.

2. Procédé selon la revendication 1,
dans lequel la mesure de la température interne de la cellule solaire en pérovskite est déterminée par spectroscopie d'impédance.

3. Procédé selon l'une quelconque des revendications 1 à 2, dans lequel la mesure de la température interne de la cellule solaire en pérovskite est déterminée au moyen d'un thermocouple.

4. Procédé selon l'une quelconque des revendications précédentes,
dans lequel le dispositif de refroidissement est situé sensiblement sur le côté du module photovoltaïque en pérovskite opposé au soleil.

5. Procédé selon l'une quelconque des revendications précédentes,
dans lequel le dispositif de refroidissement comprend un élément Peltier et, lors de l'activation du dispositif de refroidissement, un flux de courant à travers l'élément Peltier génère une réduction de la température interne de la cellule solaire en pérovskite.

6. Procédé selon l'une quelconque des revendications précédentes,
dans lequel le dispositif de refroidissement comprend un liquide de refroidissement qui présente, au moins lors de l'activation du dispositif de refroidissement, dans une admission du dispositif de refroidissement, une température inférieure à la valeur seuil de température.

7. Procédé selon l'une quelconque des revendications précédentes,
dans lequel le dispositif de refroidissement présente un radiateur pour la dissipation de chaleur par rayonnement thermique.

8. Procédé selon l'une quelconque des revendications précédentes,
dans lequel le dispositif de refroidissement présente une pluralité de canaux dans une plaque de recouvrement du module photovoltaïque en pérovskite.

9. Procédé selon la revendication 8,
dans lequel, lors de l'activation du dispositif de refroidissement, un liquide de refroidissement s'écoule à travers les canaux et absorbe une partie de l'énergie thermique de la cellule solaire en pérovskite.

10. Procédé selon l'une quelconque des revendications précédentes,
dans lequel le module photovoltaïque en pérovskite présente un cadre et la cellule solaire en pérovskite est reliée de manière thermiquement conductrice audit cadre.
